Europäisches Patentamt

European Patent Office

Office européen des brevets

(11) Publication number: **0 081 284**
A1

# EUROPEAN PATENT APPLICATION

(21) Application number: **82305252.7**

(22) Date of filing: **04.10.82**

(51) Int. Cl.³: **B 65 H 23/18**
**C 23 C 13/10**

(30) Priority: **06.10.81 GB 8130196**

(43) Date of publication of application:
**15.06.83 Bulletin 83/24**

(84) Designated Contracting States:
**DE FR GB IT**

(71) Applicant: GENERAL ENGINEERING RADCLIFFE 1979
LIMITED
Bury Road
Radcliffe Manchester, M26 9UR(GB)

(72) Inventor: Sugden, George Barry
96 Rudgwick Drive
Bury Lancashire(GB)

(74) Representative: Downey, William Gerrard et al,
WILSON, GUNN, ELLIS & CO. 41 Royal Exchange Cross
Street
Manchester M2 7BD(GB)

(54) **Device and method for rolling up flexible material webs, particularly for metallising installations.**

(57) A web metalliser comprises a vacuum chamber 27 housing a cooled treatment roll 1 disposed between a web feed 2 and a web take up 3. A draw off roll 21 driven by a motor 25 is disposed between roll 1 and take up 3. An isolating roll 12 defines a nip 13 with the surface of roll 1 on the upstream side of roll 1. It is possible to vary the tension in the web to inhibit wrinkling by controlling the speeds of draw off roll 21 and web take up 2 and by utilizing the isolation provided by nip 13 and the braking effect of brake 5.

## APPARATUS FOR WINDING A FLEXIBLE
## ELONGATE SHEET OF MATERIAL

The present invention relates to apparatus for and a method of winding a flexible elongate sheet of material and particularly, but not exclusively, to such apparatus and method, when forming part of and applied to a web metallising apparatus.

Web metallising apparatus is well known but difficulty has frequently been experienced with wrinkling and/or creasing of the web before, during or after metallising. Where wrinkling and/or creasing occurs before or during metallising a part of the web may not be uniformly metallised or the metallised web may adhere to itself or be otherwise damaged. These conditions interfere with desired continuous production methods and are virtually impossible to correct once they have occurred. The result is expense and reduced production. Damage to the web is particularly disadvantageous where the metallised layer is transferred in a subsequent process and it is required to reuse the web several times.

-2-

One arrangement for overcoming the above mentioned problems is already known. This arrangement is described in British Patent Specification No. 1,448,518 where an electrostatic attraction is produced between a web to be metallised and the treatment roll on which it is supported during metallising. However, the force necessary to overcome the electrostatic force necessary in drawing off the web from the roll does itself lead to further problems which can cause damage to the web and/or the web take up arrangement downstream of the roll.

According to one aspect of the present invention, there is provided apparatus for winding a flexible elongate sheet of material comprising a support surface for the material, means for feeding the material to the support surface and means for drawing off the material from the support surface, the means for drawing off being arranged such that, in operation, the tension of the sheet upstream of the means for drawing off exceeds that in the sheet downstream of those means.

A preferred embodiment of the apparatus of the invention may comprise any one or more of the following advantageous features:-

(a)  The support surface is the surface of a cooled roll,

(b)  The means for drawing off comprises a single driven roll,

(c)  The means for drawing off comprises two rolls defining a nip,

(d)  One of the two rolls of (c) is driven,

(e)  The driven roll is driven via a toothed belt and pulleys or gears,

(f)  The prime mover driving the driven roll via the toothed belt and pulleys or gears is an electric motor,

(g)  The driven roll is driven directly by an electric motor,

(h)  A material take up arrangement is disposed downstream of the means for drawing off,

(i)    A material feed arrangement is disposed upstream of the support surface,

(j)    The support surface and a co-operating roll form a nip near the point at which the web comes into contact with the support surface,

(k)    A spreader roll is disposed immediately upstream of the support surface to transfer the web on to the support surface before the nip of (j),

(l)    A web tension measuring device is attached to a roll disposed on the material path between the support surface and the means for drawing off,

(m)    A control is provided for controlling the drive of the driven roll of the means for drawing off in dependence upon the tension in the material sensed by the tension measuring device,

(n)    The roll of (a) is connected to a generator which in turn feeds the motor of (f) or (g),

(o)    The apparatus forms part of a metalliser in which a metallising source is disposed adjacent

-5-

the support surface.

According to another aspect of the present invention, there is provided a method of winding a flexible elongate sheet of material including the steps of feeding the material to a support surface and drawing the material off the support surface such that the tension in the material upstream of the means for drawing off the material is greater than that in the material downstream of those means.

The invention also comprises a flexible elongate sheet of material when wound by the above defined method and apparatus.

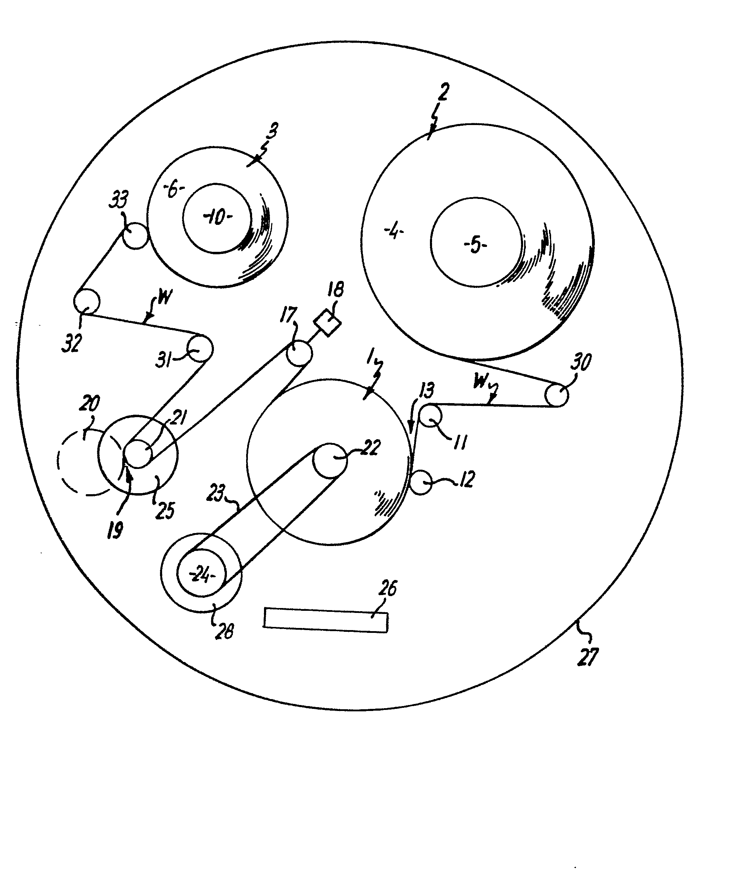

In order that the invention may be more clearly understood, one embodiment thereof will now be described, by way of example, with reference to the single figure of the accompanying drawing which shows very diagrammatically a web metalliser in accordance with the invention.

Referring to this figure, the web metalliser comprises a relatively large cooled treatment roll 1 disposed substantially midway between a web feed arrangement 2 upstream of the roll 1 and a web take up arrangement 3 downstream of the roll 1. The web feed arrangement 2 comprises a feed reel 4 to which a brake 5 is attached. An electrical generator is a convenient form of brake for this application. The take up arrangement 3 comprises a take up reel 6 which is directly driven by an electric motor 10. Alternatively a toothed belt and pulleys or gears can drivably connect the motor 10 and the reel 6.

Between roll 1 and feed reel 4 there is disposed a spreader roll 11 and, adjacent to, but spaced from roll 11, an isolating roll 12. The spreader roll 11 ensures that the full width of the web, referenced W in the figure, is delivered to the roll 1 in a substantially unwrinkled or uncreased condition. The isolating roll 12 defines a nip 13 with the roll 1 and enables the tension on the web W fed to it from the spreader roll 11 to differ from that on the web W supported on the roll 1 downstream of the roll 12.

Immediately downstream of the roll 1 is disposed a take off roll 17, which is fitted with a tension measuring device 18, such as a load cell. Between roll 17 and the web take up arrangement 3, is a draw off roll 21. Roll 21 is driven directly from an electric motor drive 25. By varying the speed of draw off roll 21, the tension in the web W as it passes round the roll 1 can be made different from that in the web as it is taken up by the take up arrangement 3. A metallising source, indicated diagrammatically at 26, comprises molten baths of the metallising metal disposed beneath and adjacent the roll 1. The whole arrangement is disposed within a closed vacuum chamber 27.

During operation of the web metalliser, as the web passes from the feed arrangement 2 round the roll 1 to the take up arrangement 3, it is possible to vary the tension in the web because of the tension isolating functions of the nip 13 and draw off roll 21. This facility is employed to provide, upstream of the nip 13 a web feed tension which is reasonably low, between the nip 13 and draw off roll 21 a web tension which is high to minimize any tendency of the web to wrinkle or crease, and downstream of the draw off roll 21 a web tension which is low enough to secure good reeling without damage to the web or the core on which it is wound.

These tensions are controlled and adjusted by appropriate adjustment of the surface speed of the reel 6 and roll 21. The reel 6 and roll 21 pull the web through the arrangement against the force of the brake 5 and also against the resistance provided by a generator 28 drivably connected to the roll 1 via pulleys 22 and 24 and toothed belt 23. This generator in turn feeds the motor 25 driving the roll 21. Roll 17 and tension measuring device 18 act as a tension monitoring device in a closed control loop which also includes the motor 25. The object of this control is to drive the draw off roll 21 at a surface speed slightly greater (say 0.5 to 2.0% greater) than the surface speed of the roll 1 and reel 6 so as to maintain a higher tension in the web W upstream of that roll 21 than in the web downstream of that roll 21 and thereby to minimize any tendency of the web W to wrinkle or crease as it passes round the roll 1 and receives metal from the source 26. Some slip between web and roll 21 and/or stretching of the web may result but neither is considered unduly disadvantageous. The web normally assumes its previous shape when the tension is released if stretching has occurred.

It will be appreciated that the above embodiment has been described by way of example only and that many variations are possible without departing from the scope of the invention.

Slip between the web and roll 21 can be reduced by giving the roll 21 a high friction surface such as rubber. A nip 19 can be formed between roll 21 and an additional roll 20, shown in dotted line in the figure, but this may damage some webs or their coatings.

Additional rolls, such as those indicated by 30, 31, 32 and 33 will be needed to guide the web between the web feed arrangement 2 and the take-up arrangement 3.

-10-

## CLAIMS

1. Apparatus for winding a flexible elongate sheet of material (W) comprising a support surface for the material, means for feeding (2) the material to the support surface and means for drawing off (21) the material from the support surface, characterised in that the means for drawing off are arranged such that, in operation, the tension of the sheet upstream of the means for drawing off (21) exceeds that in the sheet downstream of those means.

2. Apparatus as claimed in Claim 1, in which the support surface is the surface of a cooled roll (1).

3. Apparatus as claimed in claim 1 or 2, in which the means for drawing off comprises a single driven roll (21).

4. Apparatus as claimed in claim 1 or 2, in which the means for drawing off comprises two rolls (20, 21) defining a nip (19).

5. Apparatus as claimed in claim 4, in which one (21) of the two rolls is driven.

6.  Apparatus as claimed in Claim 5, in which the driven roll (21) is driven via a toothed belt and pulleys or gears.

7.  Apparatus as claimed in Claim 3,5 or 6, in which the prime mover driving the driven roll via the toothed belt and pulleys or gears is an electric motor.

8.  Apparatus as claimed in Claim 3,5 or 6 in which the driven roll (21) is driven directly by an electric motor (25).

9.  Apparatus as claimed in any preceding claim, in which a material take up arrangement (3) is disposed downstream of the means for drawing off (21).

10.  Apparatus as claimed in any preceding claim, in which the support surface and a co-operating roll (12) form a nip (13) near the point at which the material comes into contact with the support surface.

11. Apparatus as claimed in Claim 10, in which a spreader roll (11) is disposed immediately upstream of the support surface to transfer the web on to the support surface before the nip (13).

12. Apparatus as claimed in any preceding claim, in which a web tension measuring device (18) is attached to a roll (17) disposed on the material path between the support surface and the means for drawing off (21).

13. Apparatus as claimed in any of claims 5 to 8, or claims 9 to 12, when appendant directly or indirectly to claim 8, in which a control is provided for controlling the drive of the driven roll (21) of the means for drawing off in dependence upon the tension in the material sensed by the tension measuring device (18).

14. Apparatus as claimed in Claim 5, when appendant to claim 2, in which the roll (1) is connected to a generator (28) which in turn feeds a electric motor (25) connected to drive the driven roll (21).

15. Apparatus as claimed in Claim 14, in which the roll (1) is connected to the generator (28) via a toothed belt (23) and pulleys (22, 24).

16. Apparatus as claimed in any preceding claim, which forms part of a metallisor in which a metallising source is disposed adjacent the support surface.

17. A method of winding a flexible elongate sheet of material (W) including the steps of feeding the material to a support surface and drawing the material off the support surface characterised in that the tension in the material upstream of the means (27) for drawing off the material is greater than that in the material downstream of those means.

18. A method of winding a flexible elongate sheet of material as claimed in Claim 17, in which the support surface is cooled.

19. A method of winding a flexible elongate sheet of material as claimed in Claim 17 or 18, in which the material is drawn off the support surface by means of a draw off roll (21) and the speed of the roll is controlled and varied to produce the different tensions in the material upstream and downstream of the roll (21).

20.  A method of winding a flexible elongate sheet of material as claimed in Claim 17, 18 or 19 in which the material W is drawn through a nip (13) in the upstream side of the support surface to permit, in operation, a web tension upstream of the nip (13) which is relatively low compared with that downstream of the nip (13).

21.  A method of winding a flexible elongate sheet of material as claimed in any of claims 18 to 20 in which the material (W) is taken up by a take up reel (6) downstream of the means for drawing off and the speed of the reel (6) and of the means for drawing off (21) are controlled to control the tensions in the material.

22.  A flexible elongate product when wound by the method or apparatus of any preceding claim.

## EUROPEAN SEARCH REPORT

European Patent Office

| DOCUMENTS CONSIDERED TO BE RELEVANT | | | EP 82305252.7 |
|---|---|---|---|
| Category | Citation of document with indication, where appropriate, of relevant passages | Relevant to claim | CLASSIFICATION OF THE APPLICATION (Int. Cl. ³) |
| A | <u>DD - A - 151 291</u> (SCHMID)<br><br>* Totality *<br><br>-- | 1,3,6-9,17,19 | B 65 H 23/18<br>C 23 C 13/10 |
| A | PATENT ABSTRACTS OF JAPAN, unexamined applications, section C, vol. 1, no. 48, May 11, 1977<br><br>THE PATENT OFFICE JAPANESE GOVERNMENT, page 154 C 77<br><br>    * Kokai-no. 52-7877 (NISHIDA) *<br><br>-- | 1 | |
| A | PATENT ABSTRACTS OF JAPAN, unexamined applications, section C, vol. 1, no. 106, September 19, 1977<br><br>THE PATENT OFFICE JAPANESE GOVERNMENT,<br>page 2514 C 77<br><br>    * Kokai-no. 52-71389 (GIJUTSU K.K.) *<br><br>-- | 1 | TECHNICAL FIELDS SEARCHED (Int. Cl. ³)<br><br>B 65 H 23/00<br>C 23 C 13/00 |
| A | PATENT ABSTRACTS OF JAPAN, unexamined applications, section C, vol. 3, no. 32 (C-40), March 17, 1979<br><br>THE PATENT OFFICE JAPANESE GOVERNMENT,<br>page 81 C 40<br><br>    * Kokai-no. 54-6878 (FUJI SHASHIN FILM K.K.) *<br><br>-- | 1 | |

| | The present search report has been drawn up for all claims | | |
|---|---|---|---|
| X | | | |

| Place of search | Date of completion of the search | Examiner |
|---|---|---|
| VIENNA | 28-12-1982 | HOFMANN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82

**European Patent Office**

## EUROPEAN SEARCH REPORT

EP 82305252.7

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| A | PATENT ABSTRACTS OF JAPAN, unexamined applications, section C, vol. 3, no. 55 (C-45), May 11, 1979 THE PATENT OFFICE JAPANESE GOVERNMENT, page 38 C 45 * Kokai-no. 54-28782 (FUJI SHASHIN FILM K.K.) * | 1 | |
| A | PATENT ABSTRACTS OF JAPAN, unexamined applications, section C, vol. 4, no. 7 (C-70), January 19, 1980 THE PATENT OFFICE JAPANESE GOVERNMENT, page 44 C 70 * Kokai-no. 54-141393 (SANGYO K.K.) * | 1 | TECHNICAL FIELDS SEARCHED (Int. Cl. 3) |
| .A | PATENT ABSTRACTS OF JAPAN, unexamined applications, section C, vol. 5, no. 67 (C-53) (739), May 7, 1981 THE PATENT OFFICE JAPANESE GOVERNMENT, page 72 C 53 * Kokai-no. 16669 (KINZOKU K.K.) * | 1 | |
| P | EP - A2 - 0 041 850 (MATSUSHITA) * Pages 3-5; fig. 1 * | 1,17 | |
| D,A | GB - A - 1 448 518 (BRITTAINS PAPER) * Totality * | 1 | |